Europäisches Patentamt

European Patent Office

Office européen des brevets

(11) Publication number: **0 041 083**
A1

## (12) EUROPEAN PATENT APPLICATION

(21) Application number: 80301798.7

(22) Date of filing: 30.05.80

(51) Int. Cl.³: **C 23 C 13/08**
**C 23 C 15/00**

(43) Date of publication of application:
09.12.81 Bulletin 81/49

(84) Designated Contracting States:
DE FR GB

(71) Applicant: Matsushita Electric Industrial Co., Ltd.
1006, Oaza Kadoma
Kadoma-shi Osaka-fu, 571(JP)

(72) Inventor: Ohji, Kenzo
135, Higashifunahashi 2 Chome
Hirakata-shi Osaka-fu(JP)

(72) Inventor: Yamazaki, Osamu
C 1113, 6-274, Senriyamanishi
Suita-shi Osaka-fu(JP)

(72) Inventor: Wasa, Kiyotaka
7-27, Chiyogaoka 2 Chome
Nara-shi Nara-ken(JP)

(72) Inventor: Hayakawa, Shigeru
16-13, Kohrigaoka 7 Chome
Hirakata-shi Osaka-fu(JP)

(74) Representative: Crawford, Andrew Birkby et al,
A.A. THORNTON & CO. Northumberland House 303-306
High Holborn
London WC1V 7LE(GB)

(54) **Method of making a thin film.**

(57) A method of making a thin film by vapor depositing a source material onto a substrate, in which a mask plate is provided between the source material and the substrate at a location such that $d < 5\ell$ in which $d$ denotes a space between the mask plate and the substrate and $\ell$ denotes a mean free path of evaporated particles, or $s < \ell$ in which $s$ denotes a space between the mask plate and the source material. The mask plate moves relatively to the substrate and/or the source material during the deposition. The configuration of the mask plate is arranged so as to equalize deposition rates through the above-mentioned movement.

*FIG. 3A.*

*FIG. 3B.*

## Method of Making a Thin Film

This invention relates to a method of making a thin film by evaporation, and more particularly relates to an improved method of making a thin film with uniform thickness by using evaporation step which is highly practical for mass production of thin film components and devices.

Thin films are used widely for constructing electronic solid state components and devices and the thickness uniformity of such films is an important requirement in mass production. As a method of making a thin film, vacuum evaporation, sputtering and vapor phase reaction process are well known. Such methods however, have not been capable of providing a thin film of satisfactorily uniform thickness.

There has been proposed a method of compensating for variation of film thickness dependent upon the location on the substrate, in which a moving mask plate partially interrupts the evaporated source material from depositing onto the substrate, i.e., the interruption rate is varied correspondingly to the location on the substrate so as to equalize the depositing rate. Such a method is quite effective, but further improvements has been required for practical use in mass production.

The present invention provides a method of making a thin film comprising the step of vapor depositing a source material onto a substrate, in which a mask plate for equalizing depositing rates is provided between said source material and said substrate of a location such that $d < 5\ell$ in which $d$ denotes a space between said mask plate and said substrate and $\ell$ denotes a mean free path of evaporated particles, or $s < \ell$ in which $s$ denotes a space between said mask plate and said source material, said mask plate moving relatively to said substrate and/or said source material.

In order that the present invention be more readily understood, embodiments will now be described by way of example only with reference to the accompanying drawings, in which:-

Figure 1 is a schematic cross sectional view of a typical conventional vacuum deposition equipment;

Figure 2A is a plan view of a thin film obtained by the equipment of Figure 1;

Figure 2B is a graph illustrating a relative thickness distribution along a line I-I of Figure 2A;

Figure 3A is a schematic sectional view of a deposition system according to the present invention;

Figure 3B is a plan view of Figure 3A;

Figure 4 is a schematic plan view of a substrate covered with thin film, in which there are also illustrated graphs showing the film thickness distributions and relative speed of a movable mask plate to the substrate;

Figures 5A, 5B, 6A and 6B are schematic plan views of a mask plate and a source material of another embodiment of the present invention;

Figures 7A and 8A are a schematic sectional view of another deposition system according to the invention;

Figures 7B and 8B are plan views of a part of Figures 7A and 8A, respectively; and

Figure 9 is a plan view of another embodiment of a mask plate and a source material.

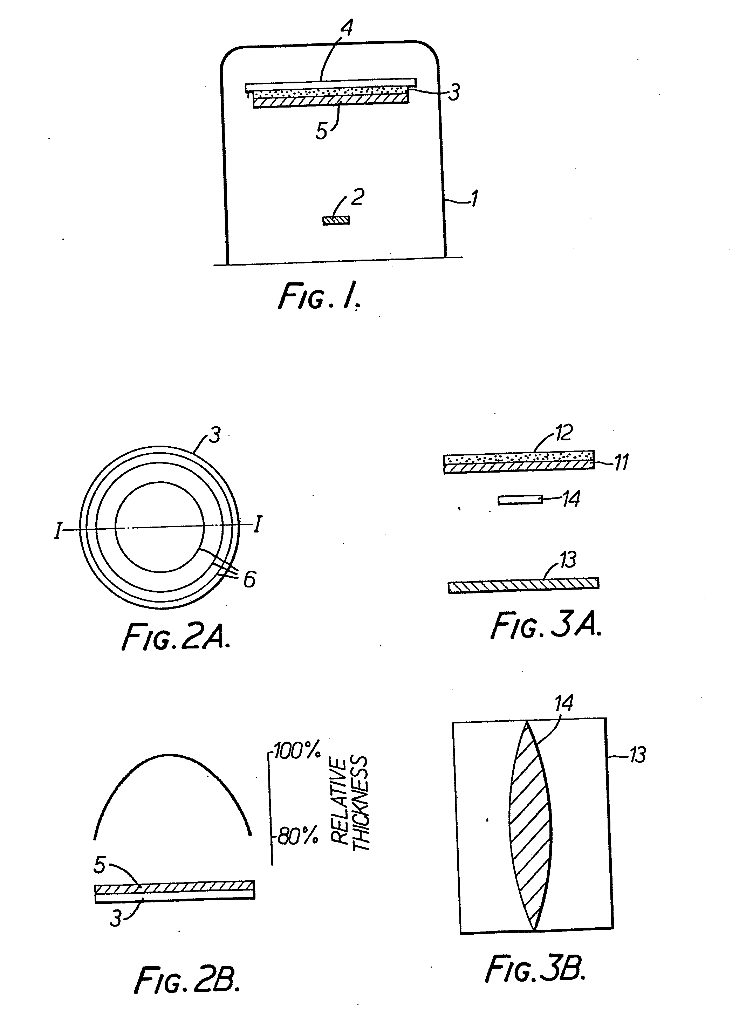

Figure 1 is a schematic illustration of a typical conventional vacuum deposition equipment. In a vacuum chamber 1, a disc of source material 2 and a substrate 3 supported by a holder 4 are placed opposite to each other, reference numeral 5 represents a deposited thin film. The deposited film 5 exhibits the thickness distribution as shown in Figures 2A and 2B. Figure 2A illustrates a plan view of the film 5 in which thickness contour lines 6 are shown and Figure 2B is a graph illustrating a thickness distribution along a line I-I of Figure 2A. As seen from these Figures, the thickness decreases from the center of the disc to the periphery. Such non-uniformity of the deposited film is due to the geometric arrangement of the source material 2 and substrate 3 and is about $\pm$ 10%.

Referring to Figures 3A and 3B, a substrate 11 is supported on a holder 12 which also serves as an anode plate on the case where sputtering is carried out. A source material 13 is placed facing the substrate 11, the source material 13 working as a cathode target if sputtering is carried out. A mask plate 14 is located between the source material 13 and the substrate 11. As shown in Figure 3B, the mask plate 14 has an ellipse-like shape whose longer axis is parallel to an edge of the source material 13 and it reciprocates in the direction at right angles to its long axis.

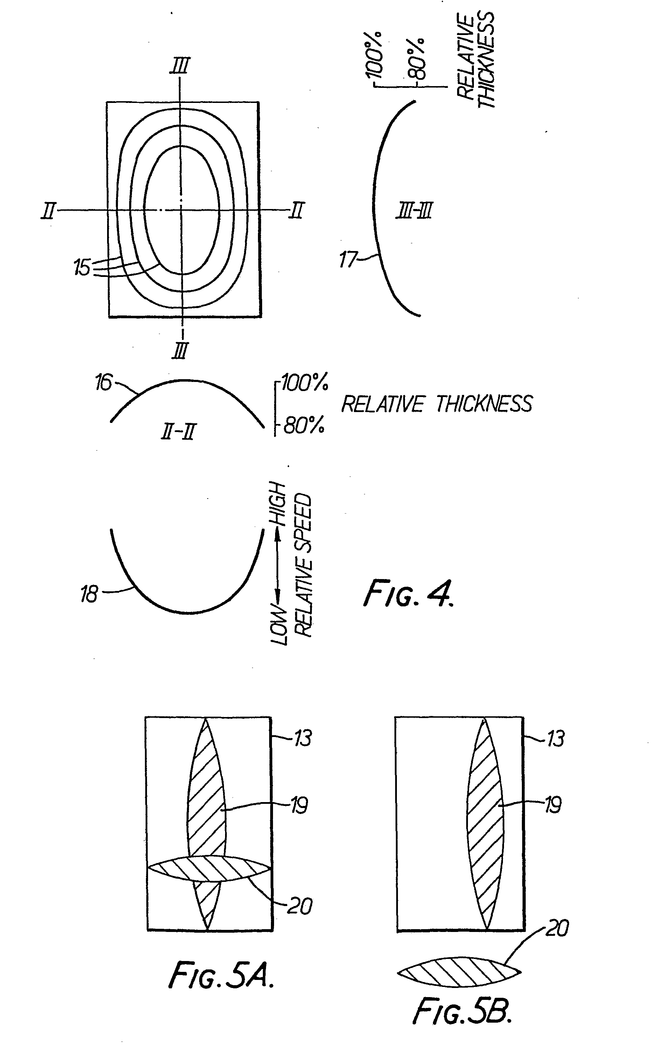

In a conventional planar diode sputtering arrangement without the mask plate 14, the obtained thin film has large thickness distributions as shown in Figure 4. Referring to Figure 4, reference numeral 15 represents contour lines of the film thickness, and 16 and 17 are graphs showing relative film thickness along lines II-II and III-III respectively.

The width of the mask plate 14 in the direction parallel to its short axis varies correspondingly to the thickness distribution of deposited film represented by relative thickness line 17 in Figure 4. That is to say, the width is large near the center areas of the substrate 11 where the film deposited without the mask plate 14 has large thickness, and the width is small in the peripheral portion where the deposited film has small thickness. Thus when the mask plate 14 reciprocates in a direction at right angles to its long axis, a period of time when the substrate 11 is covered by the mask plate 14 is longer at the center portion of the substrate 11 than at the peripheral portion. This compensates the variation, in the direction of the line III-III in Figure 4, of the depositing rate of source material 13 onto the substrate 11.

To compensate the variation of the deposition rate in the direction of the line II-II in Figure 4, the mask plate 14 reciprocates at a variable speed. Its reciprocating speed changes correspondingly to the thickness distribution of deposited film in the direction of the line II-II, which is represented by the graph 16. That is to say, the mask plate 14 moves faster at the peripheral portion of the substrate 11 than the center portion, as illustrated by graph 18 in Figure 4. Thus a period of time when the substrate 11 is covered by the mask plate 14 is longer at the center portion than at the peripheral portion.

Two manners of arrangement of spacing between the mask plate 14 and the source material or the substrate 11 is possible.

One manner is that the mask plate 14 is located near the substrate 11. A spacing between the mask plate 14 and the source material 13 is large enough not to disturb the evaporation of the source material 13. A distance $d$ between the substrate 11 and the mask plate 14 is preferably shorter than $5 \times \ell$, where $\ell$ denotes the mean free path of the evaporated particles. In a high vacuum ($< 10^{-4}$ Torr) deposition system, in which $\ell > 10$ cm, it is assumed that an evaporated particle straight only within the distance $\ell$ without any collision. Therefore when $d < \ell$, the thickness distribution is most remarkably effected by the mask plate movement.

The mask plate satisfactorily improves the distribution of the film thickness on the substrate, even

if $\underline{d} > \underline{\ell}$. For example, in a low vacuum (from $10^{-1}$ to $10^{-2}$ Torr) deposition system wherein $\underline{\ell}$ is from 0.5 to 20 mm, such as cathodic sputtering, the mask plate has a large effect on the thickness distribution. The resultant film has uniform thickness with variation of about $\pm$ 1%.

In the case where $\underline{d} > 5 \underline{\ell}$, a decrease of the thickness variation to less than $\pm$ 1% could not be achieved.

The most preferable distance $\underline{d}$ was found to be 5 to 20 mm either in high or low vacuum deposition processes. Below 5 mm, it is very difficult to position the mask plate precisely and above 20 mm the effect of the mask plate cannot be notably obtained. The other manner of spacing arrangement is that the mask plate 14 is located near the source material 13. The distance $\underline{s}$ between the mask plate and the source material is preferably within $\underline{\ell}$. In such arrangement the mask plate acts as a shield plate on the source material and therefore the sputtering area of the target is controlled so as to compensate the un-uniformity of sputtering rate.

The same result as described above can be obtained by reciprocating substrate 11 instead of moving the mask plate 14.

In conventional in-line type sputtering arrangements, in which the substrate passes over the target during an evaporation step, the dynamic facing condition between the substrate and the source material is equalized in the direction of the substrate movement. Therefore the variation of sputtering rate does not occur in such direction, and the mask plate is fixed above the source material.

The above-mentioned variation of sputtering rate in the direction of the relative movement of the mask plate to the substrate may be compensated by the other method as illustrated in Figures 5A and 5B. There are provided two elliptically-shaped mask plates 19 and 20. The longer axis of the mask plate 19 is perpendicular to that of the mask plate 20. The mask plates 19 and 20 reciprocate in the direction of the longer axis of each other. These mask plates 19 and 20 reciprocate at constant speed. The configuration of the mask plates are determined in the similar manner to that of the mask plate 14 in Figure 3. Each of Figures 5A and 5B shows a different state of the mask location during reciprocation.

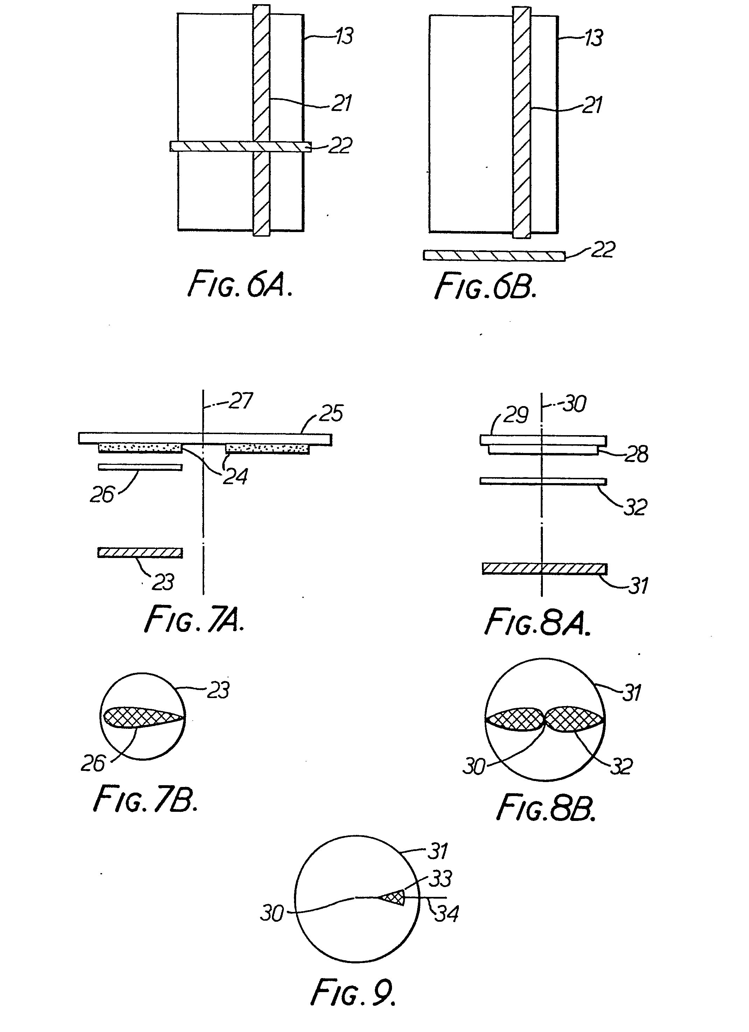

As shown in Figures 6A and 6B the masking may be performed by two rectangular mask plates 21 and 22. The longer axes of these mask plates 21 and 22 are perpendicular to each other and parallel to the edges of the source material 13. They reciprocate in the direction perpendicular to their longer axes at altering speed. The reciprocating speed is determined in the same manner as the reciprocating speed of the mask plate 14 in Figure 3, so as to compensate the sputtering rate in the direction of the reciprocation.

In the above-mentioned arrangement illustrated in Figures 5 and 6, the reciprocation of two mask plates may be performed separately, that is, one mask plate is kept out of the target when another mask plate moves.

If a pair of mask plates has the same period of reciprocation and moves simultaneously, the resultant thin film has large thickness distribution. The reason is that the same area of the substrate is very often covered with the mask plates during their reciprocation and so the deposited film is thinner at such area than at the other area of the substrate. The simultaneous reciprocation of the above two mask plates can improve the distribution of film thickness within $\pm$ 1%, if the period of the reciprocation of one mask plate is not less than three times as long as that of the other mask plate.

Further examples of the mask plate arrangement are described hereinafter.

In Figures 7A and 7B, there is shown an application of this invention to a planer diode sputtering system with a disc target 23. The target 23 faces two substrates 24 supported by a holder 25. A mask plate 26 is placed between the target 23 and the substrate 24, and has an elliptic-like form. The substrates 24 rotate more than once around a center axis 27. The longer axis of the mask plate 26 is located in the radial direction from the center axis 27.

In the example of Figures 8A and 8B, a substrate 28 placed on a holder 29 rotates more than once around its center axis 30. A disk target 31 faces to the substrate 28, with its center positioned at the center axis 30. A mask plate 32 has a shape having a reduced width at a center portion. The film thickness uniformity is further improved by rotating the mask plate 32 in addition to the rotation of the substrate 28, around the center axis 30 in the opposite direction to the substrate rotation. It also improves the film thickness uniformity to rotate the target 31 around the axis 30.

Figure 9 shows another example of the mask plate in the arrangement of Figure 8. A mask plate 33 has fan-like shape, with an axis 34 located in the radial direction of the disc target 31. The mask plate 31 reciprocates between the center 30 and the periphery of the target 31 and rotates more than once around the axis 30 during a sputtering. The relative reciprocation speed of the mask plate 33 to the target 31 is altered so as to equalize the disposition rate. Further improvement can be expected by rotating the substrate and/or the target.

In the method of the present invention, a cathodic sputtering process is very useful for the evaporation of the source material. An rf-sputtering process is convenient since various material can be evaporated. A dc-sputtering process is convenient for evaporating metallic material, since the power supply required is simple and the operation is easy. A magnetron-type cathodic sputtering process is very useful for making thin film in mass production scale since the deposition rate is very high. Especially, a planar magnetron sputtering process is convenient since the arrangement of the substrates and a target is simple. If the method according to the invention is not used, thin films obtained by using a magnetron sputtering step show a larger thickness variation than that obtained by using an ordinary diode sputtering step. Therefore, the method of the present invention is most suitable for a magnetron sputtering process.

The mask plate is preferably composed of a thin metal sheet, such as stainless steel, copper, chromium metallized spring steel, or chromium metallized bronze, which are formed to a suitable elliptic, or rectangular, or fan-like shape with ease. Furthermore, such metals degas very little in the vacuum chamber. Such metals are very conductive and are placed parallel to the target plane, so that they have the same potential as the plasma in a sputtering atmosphere and they do not disturb the plasma. The evaporation rate of the target does not show any difference between the condition with and without said mask plate, so that the improvement of the thickness distribution can be achieved without any deleterious effects.

A material having high electric resistance is preferable for holding said mask plate. Further the material for holding the mask plate preferably has high thermal conductance, because the mask plate is irradiated with heat radiated from the source material and is possibly deformed in a long sputtering run or repeated runs, causing unexpected thickness distributions. Such requirement is satisfied by a material such as beryllium oxide, aluminum oxide, or diamond.

Furthermore, in a long sputtering run or repeated runs, the mask plate is often subjected to deformation due to a stress induced by a layer of sputtered particles deposited on the mask plate. In order to reduce such deformation, the mask plate should be composed of a material which has a similar thermal expansion coefficient to that of the deposited material. The difference of thermal expansion coefficient between the mask plate and deposited material should be less than $10^{-5}/^{\circ}C$. If the difference is larger than that value, the mask plate is deformed when the deposited layer on it becomes 20 to 30 $\mu$m thick.

Further, in order to reduce the deformation of the mask plate during a sputtering step, the mask plate is preferably covered or coated with a kind of fluoride resin because the fluoride resin does not catch any sputtered particle from said source material, and is proof against high temperature of as much as $200^{\circ}C$ during a sputtering run.

CLAIMS:

1.      A method of making a thin film comprising the step of vapor depositing a source material onto a substrate, in which a mask plate for equalizing depositing rates is provided between said source material and said substrate at a location such that $\underline{d} < 5\underline{\ell}$ in which $\underline{d}$ denotes a space between said mask plate and said substrate and $\underline{\ell}$ denotes a mean free path of evaporated particles, or $\underline{s} < \underline{\ell}$ in which $\underline{s}$ denotes a space between said mask plate and said source material, said mask plate moving relatively to said substrate and/or said source material.

2.      A method as claimed in claim 1, wherein said space $\underline{d}$ ranges from 5 to 20 mm.

3.      A method as claimed in claim 1 or 2, wherein said source material is in a rectangular form, and said mask plate is in an elliptic form, whose long axis is parallel to a pair of edges of said rectangular source material, said mask plate reciprocating relatively to said substrate more than one cycle along the other pair of edges of said rectangular source material during a deposition step.

4.      A method as claimed in claim 3, wherein said mask plate varies in width in such a manner that the mask plate prevents evaporated particles of said source material at non-uniform masking rates in the direction of the longer axis of the mask plate so as to equalize deposition rates in such direction, and the speed of said reciprocation alters so that the masking rate varies in the direction of reciprocation whereby to equalize deposition rates in such direction.

- 11 -

5.      A method as claimed in claim 3, wherein there is provided a further mask plate having an elliptic form, whose long axis is perpendicular to the long axis of said first mentioned mask plate said two mask plates reciprocating at right angles to each other at constant speed.

6.      A method as claimed in claim 1, wherein said source material is in a rectangular form, and said mask plate comprises two rectangular mask plates whose long axes are perpendicular to each other and located parallel with the edges of said source material, each of the plates reciprocating perpendicular to its long axis at various speed so that the masking rates for evaporated particles of said source material varies in the directions of the respective reciprocation whereby to equalize deposition rates in such direction.

7.      A method as claimed in claim 5 or 6, wherein said two mask plates move alternately, so that one of said two mask plates is kept out of the path of particles from said source material when the other is in motion.

8.      A method as claimed in claim 5 or 6, wherein said two mask plates reciprocate independently, and a repetition period of one mask plate is not less than three times as long as that of the other.

9.      A method as claimed in claim 1, wherein said source material is in a disk form, and said mask plate is in elliptic form, whose long axis is parallel to the radial direction of said source material, and said substrate rotates more than once around its center axis during an evaporation step.

10.     A method as claimed in claim 1, wherein said source material is in a disk form, and said mask plate is in elliptic form and said substrate and said mask plate rotates more than one rotation in the opposite direction during a depositing step.

11.     A method as claimed in claim 9 or 10, wherein said source material rotates around its center axis.

12.     A method as claimed in claim 10, wherein said mask plate is in a fan-like form, whose axis of symmetry plane is parallel to the radial direction of said source material, and reciprocates along the radial direction of said source material between a center and an edge of said source material at a variable speed so that the masking rates for evaporated particles of said source material vary in the direction of the reciprocation whereby to equalize deposition rates in such direction.

13.     A method as claimed in claim 11, wherein the period of rotation of said mask plate is not less than three times as long as that of its repetition in the radial direction.

14.     A method as claimed in claim 1, wherein said deposition of said source material is performed by cathodic sputtering, which is produced by an rf or dc-power supply.

15.     A method as claimed in claim 14, wherein said cathodic sputtering is a magnetron sputtering.

16.     A method as claimed in claim 15, wherein said magnetron sputtering is a planar magnetron sputtering.

17.     A method as claimed in claim 1, wherein said mask plate is composed of a metal.

18.     A method as claimed in claim 1, wherein said mask plate is isolated electrically and is held by a material which comprises a member selected from the group consisting of beryllium oxide, aluminum oxide, and diamond.

19.     A method as claimed in claim 1, wherein said mask plate is composed of a material, which has a similar thermal expansion coefficient to that of said thin film deposited onto said substrate, the difference between them is less than $10^{-5}/^{o}C$.

20.     A method as claimed in claim 1, wherein said mask plate is coated with a fluoride resin.

FIG. I.

FIG. 2A.

FIG. 2B.

FIG. 3A.

FIG. 3B.

III

II — II

III

15

17  III-III

100%
80%
RELATIVE
THICKNESS

16  100%
80%
RELATIVE THICKNESS

II-II

18

HIGH
LOW
RELATIVE SPEED

*FIG. 4.*

13

19

20

*FIG.5A.*

13

19

20

*FIG.5B.*

3/3

FIG.6A.

FIG.6B.

FIG.7A.

FIG.8A.

FIG.7B.

FIG.8B.

FIG.9.

0041083

European Patent Office

**EUROPEAN SEARCH REPORT**

Application number

EP 80 30 1798

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| A | US - A - 3 904 503 (A.M. HANFMANN) | | C 23 C 13/08 15/00 |
| A | IBM TECHNICAL DISCLOSURE BULLETIN, vol. 14, no. 5, October 1971, New York US A.C. WONG: "Uniformity deposition corrector", page 1572 | | |
| A | US - A - 2 482 329 (G.L. DIMMICK) * Column 4, lines 1-10 * | | |
| | ---- | | |

**TECHNICAL FIELDS SEARCHED (Int. Cl.³)**

C 23 C 13/08
15/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | |
|---|---|
| The present search report has been drawn up for all claims | |

| Place of search | Date of completion of the search | Examiner |
|---|---|---|
| The Hague | 03-02-1981 | DEVISME |

EPO Form 1503.1 06.78